Europäisches Patentamt

European Patent Office

Office européen des brevets

(11) Publication number: **0 469 299 A2**

# EUROPEAN PATENT APPLICATION

(21) Application number: **91110624.3**

(22) Date of filing: **27.06.91**

(51) Int. Cl.5: **H01L 21/56, H01L 23/495**

(30) Priority: **31.07.90 IT 2113790**

(43) Date of publication of application:
**05.02.92 Bulletin 92/06**

(84) Designated Contracting States:
**DE FR GB SE**

(71) Applicant: **SGS-THOMSON
MICROELECTRONICS s.r.l.
Via C. Olivetti, 2
I-20041 Agrate Brianza Milano(IT)**

(72) Inventor: **Bassani, Mario
Via XI Febbraio 7/E
I-20056 Trezzo Sull'Adda, Milan(IT)**
Inventor: **Acquati, Renato
Via 4 Novembre, 4
I-20059 Vimercate, Milan(IT)**

(74) Representative: **Luksch, Giorgio, Dr.-Ing. et al
Ing. A. Giambrocono & C. S.r.l. Via Rosolino
Pilo, 19/b
I-20129 Milano(IT)**

(54) **Electrically well insulated support element for a silicon wafer used as a component in electrical and electronic circuits.**

(57) A support element for a silicon wafer used as a component in electrical and electronic circuits comprises a portion for receiving said wafer. According to the invention, the support element comprises at least one free edge raised at an angle to said portion, said raised edge being arranged such that, during the usual coating of the support with electrically insulating material in a known mould, it lies in front of the aperture through which said insulating material is fed into said mould, said raised edge enabling a homogeneous and uniformly thick layer of insulating material to be formed about the support element and in particular on that side of said portion opposite the side on which the silicon wafer is positioned.

Fig. 1

This invention relates to a support element for a silicon wafer used as a component in electrical and electronic circuits.

Such a support element or "island" must be electrically insulated, in the sense that to avoid interaction between the components (each comprising an island plus a silicon wafer) of any one electrical or electronic circuit, the metal supports for the silicon wafers must be electrically insulated from each other and must each allow good dissipation of the heat which develops in it during the use of the circuit.

For this reason, each island is generally positioned in the circuit with the free metal part (ie the part not supporting the silicon wafer) in direct contact with the air so that it acts as a radiator. In this case, to obtain a good compromise between electrical insulation and heat dissipation, the entire island is coated with an epoxy resin layer, the thickness of which on said free metal part is very small to allow heat dissipation.

It is however difficult to form thin homogeneous layers without defects, particularly when using high-dissipation resins containing coarse crystalline fillers.

In addition the methods used for forming electrically insulating layers of small thickness to allow heat dissipation are often costly, hence negatively affecting the marketability of the component (island plus silicon wafer).

An object of the present invention is therefore to provide a support element for a silicon wafer used as a component in electrical and electronic circuits which is well insulated electrically while at the same time being easily coolable during use.

A further object is to provide a support element of the aforesaid type in which the insulating coating is applied simply and at low coast.

A further object is to provide a support element, comprising a portion for supporting a silicon wafer, and having an insulating layer which is homogeneous and of uniform small thickness, particularly on that side of said portion opposite the side comprising the silicon wafer.

These and further objects which will be apparent to the expert of the art are attained by a support element for a silicon wafer of the aforesaid type, characterised by comprising a free edge which is raised at an angle to said portion, said raised edge being arranged such that, during the usual coating of the support with electrically insulating material in a known mould, it lies in front of the aperture through which said insulating material is fed into said mould, said raised edge enabling a homogeneous and uniformly thick layer of insulating material to be formed about the support element and in particular on that side of said portion opposite the side on which the silicon wafer is positioned.

The present invention will be more apparent from the accompanying drawing, which is provided by way of non-limiting example and in which:

Figure 1 is a perspective longitudinal sectional view of the support element constructed in accordance with the invention; and

Figure 2 is a cross-section through a support according to the invention during the stage in which it is coated with insulating material.

With reference to said figures, a support element 1 for a silicon wafer 2 comprises pins 3 for its connection to other components of an electrical circuit, not shown.

The element or island 1 comprises a portion 4, on one face 5 of which the silicon wafer 2 is present. Said island and the wafer 2 associated with it (ie the electrical component C thus defined) are covered with a coating 6 of electrically insulating material such as an epoxy resin.

As it is also necessary to dissipate the heat generated in the island 1 during the use of the component C, the resin coating 6 must be in the form of a layer which is very thin and as homogeneous as possible on that face 10 of the portion 4 opposite said face 5.

For this purpose, ie to form said layer 11, the island 1 comprises at least at a free edge 12 a raised part 13 which is inclined to said portion 4.

During the coating of the component C with the resin 6, the part 13 is arranged to lie in front of an aperture or injection channel 14 which carries the resin into a mould 15.

More specifically, during the construction of the component C, the island 1 and the relative silicon wafer 2 are positioned in said mould, which comprises two cooperating portions 16 defining a seat or cavity 17 in which the portion 4 supporting the wafer 2 is placed.

The component C is arranged in the mould 15 such that the raised part or edge 13 is in front of the channel 14.

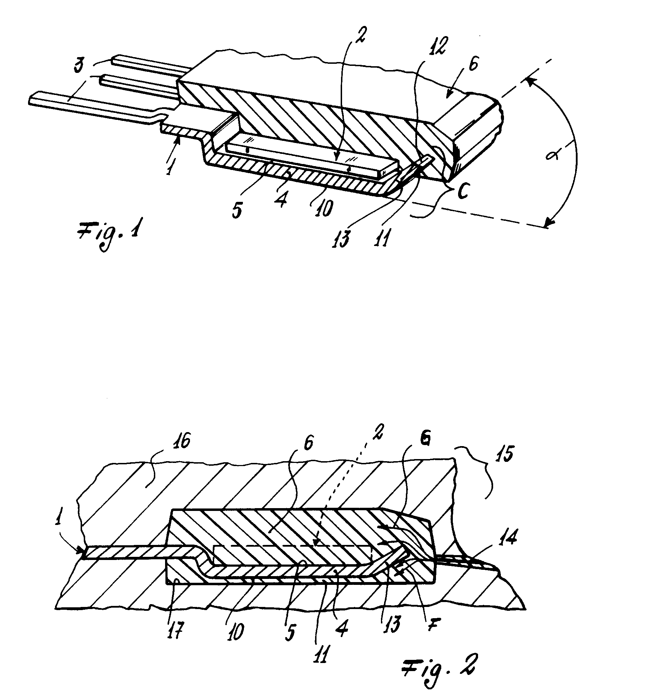

With such an arrangement, on injecting the resin into the cavity 17 of the mould 15, the resin is directed (arrows G and F) both above and below the portion 4 (relative to Figure 2) by the raised edge 13. Advantageously said edge forms an angle of between 30° and 60° with the prolongation of the portion 4.

The resin which moves in the direction of the arrow 4 reaches the face 10 of said portion 4 and, on solidifying, forms a layer 11 of such uniformity and homogeneity as to dissipate to an optimum degree the heat which develops within the support or island during the use of the component C.

With a support 1 constructed in accordance with the invention, an improvement in the cooling of the component C of which said support forms part is obtained, without having to substantially cut away the coating 6 of electrically insulating material.

The support element or island of the invention is simple to construct, and can also be formed differently, such as also providing at least one other raised edge following the edge 13 of the accompanying figures. This further edge enables the support 1 to be arranged in the mould for epoxy resin coating in a different manner and in different positions, without affecting the proper formation of the coating.

**Claims**

1.  A support element for a silicon wafer used as a component in electrical and electronic circuits, and having a portion for receiving said wafer, characterised by comprising at least one free edge (13) raised at an angle to said portion (14), said raised edge (13) being arranged such that, during the usual coating of the support (1) with electrically insulating material (6) in a known mould (15), it lies in front of the aperture (14) through which said insulating material (6) is fed into said mould (15), said raised edge (13) enabling a homogeneous and uniformly thick layer (11) of insulating material to be formed about the support element (1) and in particular on that side (10) of said portion (4) opposite the side (5) on which the silicon wafer (2) is positioned.

2.  A support element as claimed in claim 1, characterised in that the raised free edge (13) forms an angle ($\alpha$) advantageously of between $30°$ and $60°$ with the prolongation of the portion (4) which carries the silicon wafer.

Fig. 1

Fig. 2